# EUROPÄISCHE PATENTSCHRIFT

(11) **EP 1 222 695 B1**
(45) Veröffentlichungstag und Bekanntmachung des Hinweises auf die Patenterteilung: **08.08.2012**
(21) Anmeldenummer: 00982963.1
(22) Anmeldetag: 06.10.2000
(51) Int. Cl.: H01L 29/92, H01L 21/02, H01L 49/02

(54) **INTEGRIERTE SCHALTUNGSANORDNUNG MIT MINDESTENS EINEM KONDENSATOR UND VERFAHREN ZU DEREN HERSTELLUNG**
INTEGRATED CIRCUIT WITH AT LEAST ONE CAPACITOR AND METHOD FOR PRODUCING THE SAME
CIRCUIT INTEGRE COMPORTANT AU MOINS UN CONDENSATEUR ET PROCEDE DE REALISATION

(30) Priorität: 19.10.1999 DE 19950364
(43) Veröffentlichungstag der Anmeldung: 17.07.2002
(73) Patentinhaber: Qimonda AG, 81739 München (DE)
(72) Erfinder: WILLER, Josef, 85521 Riemerling (DE); HIEROLD, Christofer, 81739 München (DE)
(74) Vertreter: Epping - Hermann - Fischer
(86) Internationale Anmeldenummer: PCT/DE2000/003521
(87) Internationale Veröffentlichungsnummer: WO 2001/029900

(56) Entgegenhaltungen:
- EP-A- 0 838 852
- US-A- 5 633 781
- HORII H ET AL: "A self-aligned stacked capacitor using novel Pt electroplating method for 1 Gbit DRAMs and beyond" 1999 SYMPOSIUM ON VLSI TECHNOLOGY. DIGEST OF TECHNICAL PAPERS (IEEE CAT. NO.99CH36325), 1999 SYMPOSIUM ON VLSI TECHNOLOGY. DIGEST OF TECHNICAL PAPERS, KYOTO, JAPAN, 14-16 JUNE 1999, Seiten 103-104, XP002161639 1999, Tokyo, Japan, Japan Soc. Appl. Phys, Japan ISBN: 4-930813-93-X in der Anmeldung erwähnt

## Beschreibung

Integrierte Schaltungsanordnung mit mindestens einem Kondensator und Verfahren zu deren Herstellung.

Die Erfindung betrifft eine integrierte Schaltungsanordnung, das heißt eine Schaltungsanordnung, die in einem Substrat angeordnet ist, mit mindestens einem Kondensator.

Eine solche integrierte Schaltungsanordnung ist beispielsweise eine DRAM-Zellenanordnung mit Speicherzellen, die jeweils einen Kondensator und einen damit verbundenen Transistor aufweisen. Die Information der Speicherzelle ist in Form einer Ladung auf den Kondensator gespeichert. Bei Ansteuerung des Transistors über eine Wortleitung kann die Ladung des Kondensators über eine Bitleitung ausgelesen werden.

Zur Erhöhung der Kapazität des Kondensators bei zugleich kleinem Platzbedarf des Kondensators wird beispielsweise in H. Horii et al "A Self-aligned Stacked Capacitor using Novel Pt Electroplating Method for 1 Gbit DRAMs and Beyond", Symposium on VLSI Technology Digest of Technical Papers (1999), 103, vorgeschlagen, als Kondensatordielektrikum Barium-Strontium-Titanat (BST) zu verwenden. BST weist eine sehr hohe Dielektrizitätskonstante auf. Als Material einer zylinderförmigen ersten Kondensatorelektrode des Kondensators wird Platin verwendet. Da Platin durch Trockenätzen schwer zu strukturieren ist, wird die erste Kondensatorelektrode mittels Electroplating aufgewachsen. Dazu wird in einer ersten isolierenden Schicht eine Vertiefung erzeugt. Anschließend wird eine 40 nm dicke Haftschicht aus Ruthenium abgeschieden. Anschließend wird eine zweite isolierende Schicht erzeugt und derart strukturiert, daß die Vertiefung freigelegt wird. Durch Electroplating wächst Platin auf der Haftschicht auf und füllt die Vertiefung in der ersten isolierenden Schicht und in der zweiten isolierenden Schicht auf. Anschließend werden die zweite isolierende Schicht freiliegende Teile der Haftschicht entfernt. Zur Erzeugung eines Kondensatordielektrikums wird BST in einer Dicke von 40 nm durch Sputtern aufgebracht. Über die erforderliche zweite Kondensatorelektrode werden keine Angaben gemacht.

EP 0 838 852 A2 beschreibt die Herstellung eines zylinderförmigen Kondensators mit Platin-Elektroden und einem Dielektrikum mit hoher Dielektrizitätskonstante. Bei diesem Verfahren wird zuerst das Dielektrikum abgeschieden und anschließend die Elektroden.

US 5,633,781 beschreibt die Herstellung eines vertikal angeordneten Kondensators, der ein Elektrode aufweist, die sich aus zwei Teilen zusammensetzt. Als Dielektrika sind unter anderem auch dielektrische Materialien mit hoher Dielektrizitätszahl, insbesondere BST und andere Perowskite, angegeben. Der Erfindung liegt das Problem zugrunde, eine integrierte Schaltungsanordnung mit mindestens einem Kondensator anzugeben, die ohne Trockenätzen von schwer ätzbarem Metall zur Erzeugung von Kondensatorelektroden herstellbar ist und bei der das Kondensatordielektrikum aus einem Perowskit bestehen kann. Ferner soll ein Verfahren zur Herstellung einer solchen integrierten Schaltungsanordnung angegeben werden.

Das Problem wird gelöst durch eine integrierte Schaltungsanordnung gemäß Anspruch 1, bei der
- auf einer Oberfläche eines Substrates voneinander getrennte Anteile einer Haftschicht aus Ru, RuO2, Ir, IrO, Mo, MoO, Ta oder TaN angeordnet sind,
- auf ersten Anteilen der Haftschicht jeweils eine erste Kondensatorelektrode angeordnet ist und auf einem zweiten Anteil der Haftschicht eine zweite Kondensatorelektrode angeordnet ist, die jede erste Kondensatorelektrode seitlich vollständig umschließt,
- die erste Kondensatorelektrode und die zweite Kondensatorelektrode des jeweiligen Kondensators senkrecht zur Oberfläche des Substrats gleiche Abmessungen aufweisen und aus Platin gebildet sind,
- jeweils zwischen der ersten Kondensatorelektrode und der zweiten Kondensatorelektrode ein Kondensatordielektrikum angeordnet ist,
- die erste Kondensatorelektrode mit einem Halbleiterbauelement der Schaltungsanordnung verbunden ist und
- der Kondensator und das Halbleiterbauelement Teile einer Speicherzelle sind.

Besonders bevorzugte Ausführungsformen der integrierten Schaltungsanordnung sind in den Unteransprüchen 2 bis 4 angegeben.

Das vorgegebene Metall ist zum Beispiel Ru, RuO, Ir, IrO, Mo, MoO, Ta oder TaN. Erfindungsgemäß bestehen die erste Kondensatorelektrode und der Teil der zweiten Kondensatorelektrode aus Platin. Bei solchen Kondensatorelektroden können Kondensatordielektrika eingesetzt werden, die aus einem Perowskit, wie zum Beispiel BST oder Strontium-Wismut-Tantalat (SBT) bestehen und eine kleine Bandlücke aufweisen, da Platin eine sehr grosse Austrittsarbeit aufweist. Dies ist zur Erhöhung der Kapazität des Kondensators vorteilhaft, da solche Materialien eine hohe Dielektrizitätskonstante aufweisen.

Die der Erfindung zugrunde liegende Aufgabe wird ferner durch ein Verfahren gemäß Anspruch 5 gelöst, bei dem
- in einem ersten Schritt auf einem Substrat eine Haftschicht aus Ru, RuO2, Ir, IrO, Mo, MoO, Ta oder TaN aufgebracht wird und auf der Haftschicht eine Hilfsschicht aufgebracht wird,
- in einem zweiten Schritt in der Hilfsschicht Vertiefungen ausgebildet werden, in denen die Haftschicht freigelegt ist,
- in einem dritten Schritt in den Vertiefungen ein Material einer ersten und einer zweiten Kondensatorelektrode mindestens eines Kondensators auf die Haftschicht aufgebracht wird, wobei das Material Platin ist,
- in einem vierten Schritt die Hilfsschicht und die Haftschicht im Bereich zwischen den beiden Kondensatorelektroden des mindestens einen Kondensators entfernt werden und
- in einem fünften Schritt ein Kondensatordielektrikum zwischen die beiden Kondensatorelektroden eingebracht wird.

Die der Erfindung zugrunde liegende Aufgabe wird ferner durch ein weiteres Verfahren gemäß Anspruch 6 gelöst, bei dem
- in einem ersten Schritt auf einem Substrat eine Hilfsschicht aufgebracht wird,
- in einem zweiten Schritt in der Hilfsschicht Vertiefungen ausgebildet werden,
- in einem dritten Schritt in den Vertiefungen eine Haftschicht aus Ru, RuO2, Ir, IrO, Mo, MoO, Ta oder TaN aufgebracht wird und ein Material einer ersten und einer zweiten Kondensatorelektrode mindestens eines Kondensators auf die Haftschicht aufgebracht wird, wobei das Material Platin ist,
- in einem vierten Schritt die Hilfsschicht entfernt wird und
- in einem fünften Schritt ein Kondensatordielektrikum zwischen die beiden Kondensatorelektroden eingebracht wird.

Besonders bevorzugte Ausführungsformen der Verfahren sind in den Unteransprüchen 7 bis 9 angegeben.

Die erste Vertiefung und die zweite Vertiefung können unterschiedlich tief sein, so dass die erste Kondensatorelektrode höher als die zweite Kondensatorelektrode angeordnet ist oder umgekehrt.

Zur Erhöhung der Kapazität des Kondensators ist es vorteilhaft, wenn die zweite Kondensatorelektrode die erste Kondensatorelektrode seitlich umgibt. Dazu wird die zweite Vertiefung so erzeugt, dass sie die erste Vertiefung seitlich umgibt.

Die Haftschicht wird beispielsweise vor Erzeugung der Hilfsschicht auf das Substrat aufgebracht. Die erste Vertiefung und die zweite Vertiefung werden so erzeugt, dass sie bis zur Haftschicht reichen. Vorzugsweise wirkt die Haftschicht als Ätzstop. Insbesondere, wenn die Haftschicht aus leitendem Material, wie zum Beispiel aus Ru, RuO, Ir, IrO, Mo, MoO, Ta oder TaN besteht, ist es zur Vermeidung von Leckströmen vorteilhaft, den ersten Teil der Haftschicht vom zweiten Teil der Haftschicht zu trennen. Dazu werden nach Entfernung der Hilfsschicht freiliegende Teile der Haftschicht durch anisotropes Ätzen entfernt.

Alternativ wird die Haftschicht nach Erzeugung der ersten Vertiefung und der zweiten Vertiefung erzeugt. Zur Entfernung von Teilen der Haftschicht, die ausserhalb der Vertiefungen, das heisst auf einer oberen Oberfläche der Hilfsschicht angeordnet sind, zu entfernen, können die erste Vertiefung und die zweite Vertiefung mit Lack gefüllt werden. Anschliessend werden die freiliegenden Teile der Haftschicht entfernt.

Es liegt im Rahmen der Erfindung, zwischen dem ersten Teil und dem zweiten Teil der Haftschicht eine Füllstruktur anzuordnen, die eine grössere Bandlücke aufweist als das Kondensatordielektrikum, um Leckströme zwischen den Teilen der Haftschicht zu verringern. Das Kondensatordielektrikum ist auf der Füllstruktur angeordnet. Dazu wird nach Trennung des ersten Teils der Haftschicht vom zweiten Teil der Haftschicht mindestens die Füllstruktur erzeugt, die zwischen dem ersten Teil und dem zweiten Teil der Haftschicht angeordnet ist und diese elektrisch voneinander trennt.

Es liegt im Rahmen der Erfindung, vor Erzeugung des Kondensators ein Halbleiterbauelement der Schaltungsanordnung zu erzeugen. Die erste Kondensatorelektrode wird auf dem Halbleiterbauelement erzeugt und mit diesem verbunden.

Das Halbleiterbauelement ist beispielsweise ein Transistor.

Die Schaltungsanordnung ist beispielsweise eine Speicherzellenanordnung mit gleichartig ausgestalteten Speicherzellen. Der Kondensator und das Halbleiterbauelement sind Teil einer der Speicherzellen.

Zur Erhöhung der Packungsdichte der Speicherzellenanordnung ist es vorteilhaft, wenn die zweiten Kondensatorelektroden der Kondensatoren der Speicherzellen zusammenhängen, so daß sie nicht einzeln kontaktiert werden müssen. Eine solche Schaltungsanordnung kann beispielsweise erzeugt werden, indem bei der Erzeugung der ersten und der zweiten Vertiefungen nur Teile der Hilfsschicht übrigbleiben, die die zu erzeugenden ersten Kondensatorelektroden der Kondensatoren der Speicherzellen seitlich umgeben. Diese Teile der Hilfsschicht werden später durch das Kondensatordielektrikum und eventuell durch die Füllstrukturen ersetzt. Die zweiten Vertiefungen hängen zusammen.

Beispielsweise handelt es sich bei der Speicherzellenanordnung um eine DRAM-Zellenanordnung, deren Speicherzellen jeweils einen Kondensator und einen damit verbundenen Transistor umfassen. Die Speicherzellen sind mit Wortleitungen und quer dazu verlaufenden Bitleitungen verbunden.

Bei der Speicherzellenanordnung kann es sich auch um eine FRAM-Zellenanordnung (ferroelectric random access memory) handeln. In diesem Fall besteht das Kondensatordielektrikum aus einem ferromagnetischen Material, wie zum Beispiel Pb(Zr,Ti)O₃.

Die zusammenhängenden zweiten Vertiefungen können beispielsweise wie folgt erzeugt werden:

Auf der Hilfsschicht werden Hilfsstrukturen erzeugt, die selektiv zur Hilfsschicht ätzbar sind und die jeweils eine der zu erzeugenden ersten Vertiefungen bedecken. An seitlichen Flächen der Hilfsstrukturen werden Spacer erzeugt, die selektiv zu den Hilfsstrukturen und zur Hilfsschicht ätzbar sind. Die Hilfsstrukturen werden selektiv zu den Spacern und zur Hilfsschicht entfernt. Die Hilfsstrukturen dienen also als Stufe, um die Erzeugung der Spacer durch Abscheiden und Rückätzen von Material zu ermöglichen, wobei die Spacer jeweils eine der zu erzeugenden ersten Vertiefungen umgeben. Anschließend werden die ersten Vertiefungen und die zusammenhängenden zweiten Vertiefungen durch Ätzen der Hilfsschicht selektiv zu den Spacern erzeugt.

Die Dicke der Spacer bestimmt die Dicke des Kondensatordielektrikums.

Die Hilfsschicht besteht beispielsweise aus Polysilizium, aus SiO₂ oder aus Siliziumnitrid.

Die Spacer und die Füllstrukturen bestehen beispielsweise aus SiO₂ oder aus Siliziumnitrid.

Die Hilfsstrukturen bestehen beispielsweise aus Polysilizium, oder aus Siliziumnitrid.

Im folgenden wird ein Ausführungsbeispiel der Erfindung anhand der Figuren näher erläutert.
Figur 1a zeigt einen ersten Querschnitt durch ein Substrat, nachdem Transistoren, Wortleitungen (nicht dargestellt), Bitleitungen (nicht dargestellt), Kontakte, ein Zwischenoxid, eine Haftschicht, eine Hilfsschicht, Hilfsstrukturen und Spacer erzeugt wurden.
Figur 1b zeigt einen zum Querschnitt aus Figur 1a senkrechten Querschnitt durch das Substrat nach den Prozeßschritten aus Figur 1a.
Figur 2a zeigt den Querschnitt aus Figur 1a, nachdem die Hilfsstrukturen entfernt wurden und erste Vertiefungen und zweite Vertiefungen erzeugt wurden.
Figur 2b zeigt den Querschnitt aus Figur 1b, nach den Prozeßschritten aus Figur 2a.
Figur 3a zeigt den Querschnitt aus Figur 2a, nachdem erste Kondensatorelektroden von Kondensatoren, zweite Kondensatorelektroden der Kondensatoren, Isolationen und Füllstrukturen erzeugt wurden.
Figur 3b zeigt den Querschnitt aus Figur 2b nach den Prozeßschritten aus Figur 3a.
Figur 4a zeigt den Querschnitt aus Figur 3a, nachdem ein Kondensatordielektrikum und ein weiteres Zwischenoxid erzeugt wurden.
Figur 4b zeigt den Querschnitt aus Figur 3b nach den Prozeßschritten aus Figur 4a.
Figur 4c zeigt eine Aufsicht auf das Substrat, in der die ersten Kondensatorelektroden, das Kondensatordielektrikum und die zweiten Kondensatorelektroden dargestellt sind.

Die Figuren sind nicht maßstabsgerecht.

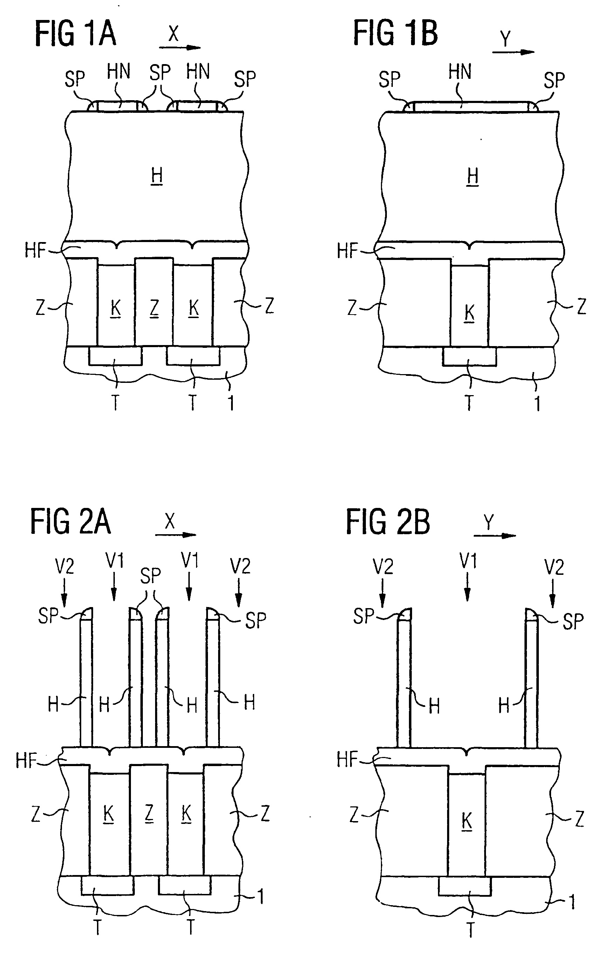

In einem Ausführungsbeispiel ist als Ausgangsmaterial ein erstes Substrat 1 aus Silizium vorgesehen. Im Bereich einer Oberfläche des Substrats 1 werden Transistoren T erzeugt (siehe Figuren 1a und 1b). Gateelektroden der Transistoren T werden mit Wortleitungen verbunden, die parallel zu einer X-Achse X verlaufen. Erste Source-/Drain-Gebiete der Transistoren T werden mit Bitleitungen verbunden, die parallel zur einer Y-Achse Y verlaufen. Die Y-Achse Y verläuft senkrecht zur X-Achse X.

Auf den Transistoren T wird ein ca. 500 nm dickes Zwischenoxid Z aus SiO₂ erzeugt (siehe Figuren 1a und 1b). Im Zwischenoxid Z werden Kontakte K zu zweiten Source-/Drain-Gebieten der Transistoren T erzeugt. Die Kontakte K bestehen aus dotiertem Polysilizium. Die Kontakte K weisen einen kreisförmigen horizontalen Querschnitt mit einem Durchmesser von ca. 100 nm auf. Entlang der X-Achse X zueinander benachbarter Kontakte K weisen einen Abstand von ca. 100 nm voneinander auf. Entlang der Y-Achse Y zueinander benachbarter Kontakte K weisen einen Abstand von ca. 300 nm voneinander auf.

Die Kontakte K werden ca. 30 nm tief rückgeätzt, so daß eine obere Oberfläche des Zwischenoxids Z ca. 30 nm höher liegt als eine obere Oberfläche der Kontakte K. Anschließend wird eine ca. 50 nm dicke Haftschicht HF aus RuO₂ abgeschieden. Darüber wird eine ca. 500 nm Hilfsschicht H aus SiO₂ erzeugt (siehe Figuren 1a und 1b).

Zur Erzeugung von Hilfsstrukturen HN wird Polysilizium in einer Dicke von ca. 100 nm abgeschieden und durch ein photolithographisches Verfahren strukturiert. Eine zur X-Achse X parallele Abmessung einer der Hilfsstrukturen HN beträgt ca. 100 nm. Eine zur Y-Achse Y parallele Abmessung der Hilfsstruktur HN beträgt ca. 300 nm (siehe Figuren 1a und 1b). Die Hilfsstrukturen HN sind jeweils über einem der Kontakte K angeordnet.

Zur Erzeugung von Spacern SP wird Siliziumnitrid in einer Dicke von ca. 35 nm abgeschieden und rückgeätzt (siehe Figuren 1a und 1b).

Anschließend werden die Hilfsstrukturen HN mit zum Beispiel HBr selektiv zu den Spacern SP und der Hilfsschicht H entfernt. Durch Ätzen von SiO₂ selektiv zu den Spacern SP werden erste Vertiefungen V1 und zusammenhängende zweite Vertiefungen V2 in der Hilfsschicht H erzeugt, die bis zur Haftschicht HF reichen (siehe Figuren 2a und 2b). Die ersten Vertiefungen V1 sind unter den entfernten Hilfsstrukturen HN angeordnet. Übrigbleibende Teile der Hilfsschicht H umgeben die ersten Vertiefungen V1 seitlich.

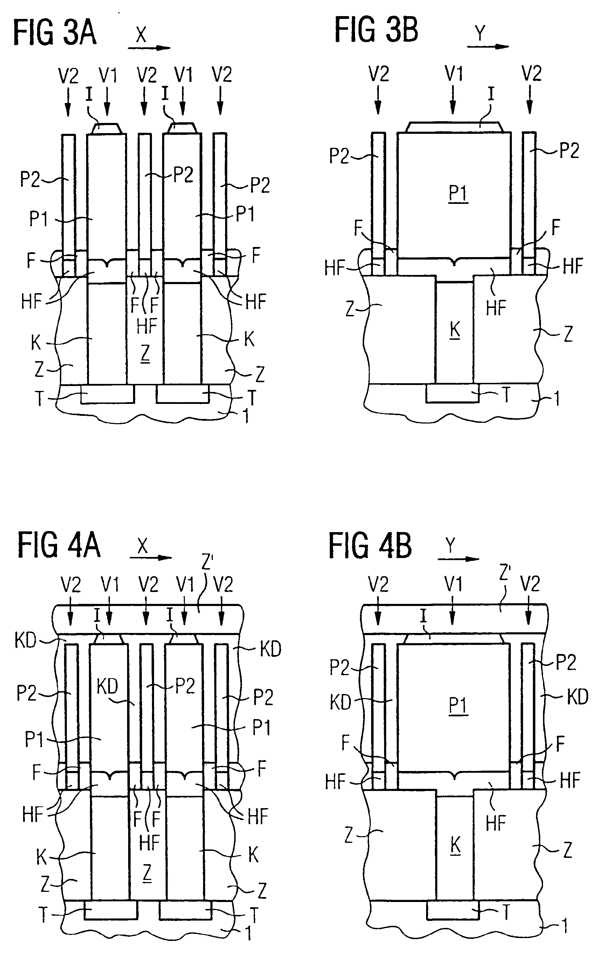

Durch Electroplating wird Platin auf die Haftschicht HF aufgewachsen, bis die ersten Vertiefungen V1 und die zweiten Vertiefungen V2 mit Platin gefüllt werden. Dadurch entstehen in den ersten Vertiefungen V1 erste Kondensatorelektroden P1 von Kondensatoren (siehe Figuren 3a und 3b). In den zusammenhängenden zweiten Vertiefungen V2 entstehen zusammenhängende zweite Kondensatorelektroden P2 der Kondensatoren.

Anschließend werden die Spacer SP und die übrigbleibenden Teile der Hilfsschicht H entfernt. Durch anisotropes Ätzen von RuO₂ wird die Haftschicht HF strukturiert, so daß unter den ersten Kondensatorelektroden P1 angeordnete erste Teile der Haftschicht HF von unter den zusammenhängenden zweiten Teilen der Kondensatorelektroden P2 angeordneten zweiten Teile der Haftschicht HF getrennt werden (siehe Figuren 3a und 3b).

Durch einen HDP-Prozeß wird SiO₂ derart abgeschieden und isotrop rückgeätzt, daß zwischen den ersten Teilen und den zweiten Teilen der Haftschicht HF ca. 50 nm dicke Füllstrukturen F aus SiO₂ erzeugt werden. Aufgrund der Füllstrukturen F liegen die ersten Teile und die zweiten Teile der Haftschicht HF nicht mehr frei. Beim HDP-Prozeß entstehen auch Isolationen I auf den ersten Kondensatorelektroden P1.

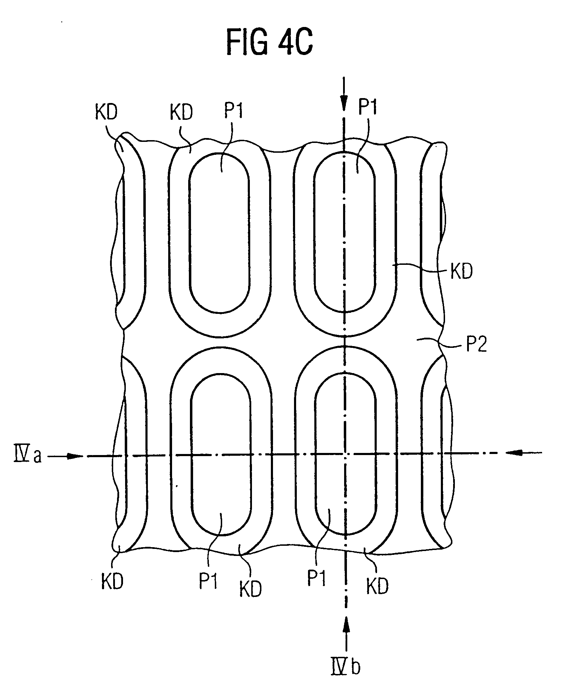

Zur Erzeugung eines Kondensatordielektrikum KD der Kondensatoren wird BST mit einem Sol-Gel-Verfahren aufgeschleudert und thermisch verdichtet. Anschließend wird das BST rückgeätzt, bis die Isolationen I freigelegt werden (siehe Figuren 4a, 4b und 4c). Anschließend wird ein weiteres ca. 200 nm dickes Zwischenoxid Z' aus SiO₂ erzeugt (siehe Figuren 4a und 4b).

Im Ausführungsbeispiel wird eine DRAM-Zellenanordnung erzeugt, deren Speicherzellen jeweils einen der Kondensatoren und einen der Transistoren T umfassen. Die ersten Kondensatorelektroden P1 sind über die Kontakte K mit den Transistoren T verbunden.

Es sind viele Variationen des Ausführungsbeispiels denkbar, die ebenfalls im Rahmen der Erfindung liegen. So können Abmessungen der beschriebenen Schichten, Strukturen und Vertiefungen an die jeweiligen Erfordernisse angepaßt werden. Dasselbe gilt für die Wahl der Materialien.

## Patentansprüche

1. Integrierte Schaltungsanordnung mit mindestens einem Kondensator, bei der
- auf einer Oberfläche eines Substrates (1) voneinander getrennte Anteile einer Haftschicht (HF) aus Ru, RuO2, Ir, IrO, Mo, MoO, Ta oder TaN angeordnet sind,
- auf ersten Anteilen der Haftschicht (HF) jeweils eine erste Kondensatorelektrode (P1) angeordnet ist und auf einem zweiten Anteil der Haftschicht (HF) eine zweite Kondensatorelektrode (P2) angeordnet ist, die jede erste Kondensatorelektrode (P1) seitlich vollständig umschließt,
- die erste Kondensatorelektrode (P1) und die zweite Kondensatorelektrode (P2) des jeweiligen Kondensators senkrecht zur Oberfläche des Substrats gleiche Abmessungen aufweisen und aus Platin gebildet sind,
- jeweils zwischen der ersten Kondensatorelektrode (P1) und der zweiten Kondensatorelektrode (P2) ein Kondensatordielektrikum (KD) angeordnet ist,
- die erste Kondensatorelektrode (P1) mit einem Halbleiterbauelement der Schaltungsanordnung verbunden ist und
- der Kondensator und das Halbleiterbauelement Teile einer Speicherzelle sind.

2. Schaltungsanordnung nach Anspruch 1, bei der zwischen den jeweiligen ersten Anteilen und dem zweiten Anteil der Haftschicht (HF) jeweils eine Füllstruktur (F) angeordnet ist, wobei das Material der Füllstruktur eine größere Bandlücke aufweist als das Kondensatordielektrikum (KD), und das Kondensatordielektrikum (KD) auf der Füllstruktur (F) angeordnet ist.

3. Schaltungsanordnung nach einem der Ansprüche 1 bis 2, bei der
das Kondensatordielektrikum (KD) ein Material aus der Gruppe von Barium-Strontium-Titanat, Strontium-Wismut-Tantalat und Pb(Zr,Ti)O₃ ist.

4. Schaltungsanordnung nach einem der Ansprüche 1 bis 3, bei der
eine Mehrzahl von Kondensatoren vorhanden ist, die auf Anteilen der Haftschicht (HF) jeweils eine erste Kondensatorelektrode (P1) und eine zweite Kondensatorelektrode (P2) seitlich einander gegenüber angeordnet aufweisen, wobei die jeweils zweiten Kondensatorelektroden (P2) zusammenhängen.

5. Verfahren zur Herstellung einer integrierten Schaltungsanordnung mit mindestens einem Kondensator, bei dem
- in einem ersten Schritt auf einem Substrat (1) eine Haftschicht (HF) aus Ru, RuO2, Ir, IrO, Mo, MoO, Ta oder TaN aufgebracht wird und auf der Haftschicht (HF) eine Hilfsschicht (H) aufgebracht wird,
- in einem zweiten Schritt in der Hilfsschicht (H) Vertiefungen (V1, V2) ausgebildet werden, in denen die Haftschicht (HF) freigelegt ist,
- in einem dritten Schritt in den Vertiefungen (V1, V2) ein Material einer ersten (P1) und einer zweiten Kondensatorelektrode (P2) mindestens eines Kondensators auf die Haftschicht (HF) aufgebracht wird, wobei das Material Platin ist,
- in einem vierten Schritt die Hilfsschicht (H) und die Haftschicht (HF) im Bereich zwischen den beiden Kondensatorelektroden (P1, P2) des mindestens einen Kondensators entfernt werden und
- in einem fünften Schritt ein Kondensatordielektrikum (KD) zwischen die beiden Kondensatorelektroden (P1, P2) eingebracht wird.

6. Verfahren zur Herstellung einer integrierten Schaltungsanordnung mit mindestens einem Kondensator, bei dem
- in einem ersten Schritt auf einem Substrat (1) eine Hilfsschicht (H) aufgebracht wird,
- in einem zweiten Schritt in der Hilfsschicht (H) Vertiefungen (V1, V2) ausgebildet werden,
- in einem dritten Schritt in den Vertiefungen (V1, V2) eine Haftschicht (HF) aus Ru, Ru02, Ir, IrO, Mo, MoO, Ta oder TaN aufgebracht wird und ein Material einer ersten (P1) und einer zweiten Kondensatorelektrode (P2) mindestens eines Kondensators auf die Haftschicht (HF) aufgebracht wird, wobei das Material Platin ist,
- in einem vierten Schritt die Hilfsschicht (H) entfernt wird und
- in einem fünften Schritt ein Kondensatördielektrikum (KD) zwischen die beiden Kondensatorelektroden (P1, P2) eingebracht wird.

7. Verfahren nach Anspruch 5 oder 6, bei dem in dem zweiten Schritt die Vertiefungen (V1, V2) ausgebildet werden, indem auf der Hilfsschicht (H) Hilfsstrukturen (HN) erzeugt werden, die selektiv zur Hilfsschicht (H) ätzbar sind und seitliche Flächen aufweisen,
an den seitlichen Flächen der Hilfsstrukturen (HN) Spacer (SP) erzeugt werden, bezüglich deren die Hilfsstrukturen (HN) und die Hilfsschicht (H) selektiv ätzbar sind,
die Hilfsstrukturen (HN) selektiv zu den Spacern (SP) entfernt werden und
die Vertiefungen (V1, V2) durch Ätzen der Hilfsschicht (H) selektiv zu den Spacern (SP) erzeugt werden.

8. verfahren nach einem der Ansprüche 5 bis 7, bei dem in dem dritten Schritt das Platin für die Kondensatorelektroden (P1, P2) mittels Electroplating aufgebracht wird.

9. verfahren nach einem der Ansprüche 5 bis 8, bei dem eine Füllstruktur (F) im Bereich zwischen den Kondensatorelektroden (P1, P2) erzeugt wird, so dass die Füllstruktur (F) Anteile der Haftschicht (HF) trennt, und
das Kondensatordielektrikum (KD) auf der Füllstruktur (F) erzeugt wird.

## Claims

1. An integrated circuitry comprising at least one capacitor, in which
- separate portions of an adhesion layer (HF) which is made of Ru, RuO₂, Ir, IrO, Mo, MoO, Ta or TaN are arranged on a surface of a substrate (1),
- a first capacitor electrode (P1) is arranged on each of first portions of the adhesion layer (HF) and a second capacitor electrode (P2) is arranged on a second portion of the adhesion layer (HF), the second capacitor electrode laterally completely enclosing each of the first capacitor electrodes (P1),
- the first capacitor electrode (P1) and the second capacitor electrode (P2) of the respective capacitor have identical dimensions perpendicular to the surface of the substrate and are formed from platinum,
- a capacitor dielectric material (KD) being arranged in each case between the first capacitor electrode (P1) and the second capacitor electrode (P2),
- the first capacitor electrode (P1) being connected to a semiconductor element of the circuitry and
- the capacitor and the semiconductor element being parts of a memory cell.

2. The circuitry according to claim 1, in which a filling structure (F) is arranged between the respective first portions and the second portion of the adhesion layer (HF), the material of the filling structure having a larger band gap than the capacitor dielectric material (KD), and the capacitor dielectric material (KD) being arranged on the filling structure (F).

3. The circuitry according to any of the claims 1 to 2, in which
the capacitor dielectric material (KD) is a material from the group consisting of barium strontium titanate, strontium bismuth tantalate and Pb(Zr,Ti)O₃.

4. The circuitry according to any of the claims 1 to 3, in which
a plurality of capacitors is provided, each comprising a first capacitor electrode (P1) and a second capacitor electrode (P2) on portions of the adhesion layer (HF) so as to be laterally opposite each other, the second capacitor electrodes (P2) all being linked to one another.

5. A method of manufacturing an integrated circuitry comprising at least one capacitor, in which
- an adhesion layer (HF) made of Ru, RuO₂, Ir, IrO, Mo, MoO, Ta or TaN is applied on a substrate (1) and an auxiliary layer (H) is applied on the adhesion layer (HF) in a first step,
- indentations (V1, V2) are formed in the auxiliary layer (H) in a second step, the adhesion layer (HF) being exposed in the indentations,
- a material of a first capacitor electrode (P1) and of a second capacitor electrode (P2) of at least one capacitor is applied on the adhesion layer (HF) in the indentations (V1, V2) in a third step, the material being platinum,
- the auxiliary layer (H) and the adhesion layer (HF) being removed in the area between the two capacitor electrodes (P1, P2) of the at least one capacitor in a fourth step and
- a capacitor dielectric material (KD) is introduced between the two capacitor electrodes (P1, P2) in a fifth step.

6. A method of manufacturing an integrated circuitry comprising at least one capacitor, in which
- an auxiliary layer (H) is applied on a substrate (1) in a first step,
- indentations (V1, V2) are formed in the auxiliary layer (H) in a second step,
- an adhesion layer (HF) made of Ru, RuO₂, Ir, IrO, Mo, MoO, Ta or TaN is applied in the indentations (V1, V2) and a material of a first capacitor electrode (P1) and of a second capacitor electrode (P2) of at least one capacitor is applied on the adhesion layer (HF) in a third step, the material being platinum,
- the auxiliary layer (H) is removed in a fourth step, and
- a capacitor dielectric material (KD) is introduced between the two capacitor electrodes (P1, P2) in a fifth step.

7. The method according to claim 5 or 6, in which the indentations (V1, V2) are formed in the second step by producing auxiliary structures (HN) on the auxiliary layer (H), the auxiliary structures being able to be selectively etched with respect to the auxiliary layer (H) and comprising lateral faces,
spacers (SP) are produced on the lateral faces of the auxiliary structures (HN), the auxiliary structures (HN) and the auxiliary layer (H) being able to be selectively etched with respect to the spacers,
the auxiliary structures (HN) are selectively removed with respect to the spacers (SP) and
the indentations (V1, V2) are produced by etching the auxiliary layer (H) selectively with respect to the spacers (SP).

8. The method according to any of the claims 5 to 7, in which
the platinum for the capacitor electrodes (P1, P2) is applied in the third step by means of electroplating.

9. The method according to any of the claims 5 to 8, in which
a filling structure (F) is produced in the area between the capacitor electrodes (P1, P2) so that the filling structure (F) separates portions of the adhesion layer (HF), and the capacitor dielectric material (KD) is produced on the filling structure (F).

## Revendications

1. Circuit intégré comprenant au moins un condensateur, dans lequel
- des parts séparées l'une de l'autre d'une couche d'adhérence (HF) en Ru, Ru02, Ir, IrO, Mo, MoO, Ta ou TaN sont disposées sur une surface d'un substrat (1),
- sur des premières parts de la couche d'adhérence (HF) est disposée respectivement une première électrode de condensateur (P1) et sur une deuxième part de la couche d'adhérence (HF) est disposée une deuxième électrode de condensateur (P2) qui entoure entièrement chaque première électrode de condensateur (P1) latéralement,
- la première électrode de condensateur (P1) et la deuxième électrode de condensateur (P2) du condensateur respectif présentent des dimensions identiques perpendiculairement à la surface du substrat et sont constituées de platine,
- un diélectrique de condensateur (KD) est disposé respectivement entre la première électrode de condensateur (P1) et la deuxième électrode de condensateur (P2),
- la première électrode de condensateur (P1) est reliée à un composant semiconducteur du circuit et
- le condensateur et le composant semiconducteur sont des parties d'une cellule de mémoire.

2. Circuit selon la revendication 1, dans lequel respectivement une structure de remplissage (F) est disposée entre les premières parts respectives et la deuxième part de la couche d'adhérence (HF), le matériau de la structure de remplissage (F) présentant une plus grande bande interdite que le diélectrique de condensateur (KD), et le diélectrique de condensateur (KD) est disposé sur la structure de remplissage (F).

3. Circuit selon l'une des revendications 1 à 2, dans lequel
le diélectrique de condensateur (KD) est un matériau issu du groupe comprenant le titanate de baryum-strontium, le tantalate de strontium-bismuth et Pb(Zr,Ti)03.

4. Circuit selon l'une des revendications 1 à 3, dans lequel
est présente une pluralité de condensateurs qui présentent sur des parts de la couche d'adhérence (HF) respectivement une première électrode de condensateur (P1) et une deuxième électrode de condensateur (P2) disposées en face l'une de l'autre latéralement, les respectivement deuxièmes électrodes de condensateur (P2) étant attenantes.

5. Procédé de fabrication d'un circuit intégré comprenant au moins un condensateur, dans lequel
- à une première étape, une couche d'adhérence (HF) en Ru, Ru02, Ir, IrO, Mo, MoO, Ta ou TaN est appliquée sur un substrat (1) et une couche auxiliaire (H) est appliquée sur la couche d'adhérence (HF),
- à une deuxième étape, des cavités (V1, V2) dans lesquelles la couche d'adhérence (HF) est dégagée, sont constituées dans la couche auxiliaire (H),
- à une troisième étape, un matériau d'une première (P1) et d'une deuxième électrode de condensateur (P2) d'au moins un condensateur est appliqué dans les cavités (V1, V2) sur la couche d'adhérence (HF), le matériau étant du platine,
- à une quatrième étape, la couche auxiliaire (H) et la couche d'adhérence (HF) sont enlevées dans la zone située entre les deux électrodes de condensateur (P1, P2) de l'au moins un condensateur et
- à une cinquième étape, un diélectrique de condensateur (KD) est inséré entre les deux électrodes de condensateur (P1, P2).

6. Procédé de fabrication d'un circuit intégré comprenant au moins un condensateur, dans lequel
- à une première étape, une couche auxiliaire (H) est appliquée sur un substrat (1),
- à une deuxième étape, des cavités (V1, V2) sont constituées dans la couche auxiliaire (H),
- à une troisième étape, une couche d'adhérence (HF) en Ru, Ru02, Ir, IrO, Mo, MoO, Ta ou TaN est appliquée dans les cavités (V1, V2) et un matériau d'une première (P1) et d'une deuxième électrode de condensateur (P2) d'au moins un condensateur est appliqué sur la couche d'adhérence (HF), le matériau étant du platine,
- à une quatrième étape, la couche auxiliaire (H) est enlevée et
- à une cinquième étape, un diélectrique de condensateur (KD) est inséré entre les deux électrodes de condensateur (P1, P2).

7. Procédé selon la revendication 5 ou 6, dans lequel, à la deuxième étape, les cavités (V1, V2) sont constituées en ce que des structures auxiliaires (HN) qui sont attaquables sélectivement par rapport à la couche auxiliaire (H) et présentent des surfaces latérales, sont générées sur la couche auxiliaire (H),
des espaceurs (SP) par rapport auxquels les structures auxiliaires (HN) et la couche auxiliaire (H) sont attaquables sélectivement, sont générés sur les surfaces latérales des structures auxiliaires (HN),
les structures auxiliaires (HN) sont enlevées sélectivement par rapport aux espaceurs (SP) et
les cavités (V1, V2) sont générées par attaque de la couche auxiliaire (H) sélectivement par rapport aux espaceurs (SP).

8. Procédé selon l'une des revendications 5 à 7, dans lequel, à la troisième étape, le platine pour les électrodes de condensateur (P1, P2) est appliqué par électroplacage.

9. Procédé selon l'une des revendications 5 à 8, dans lequel une structure de remplissage (F) est générée dans la zone située entre les électrodes de condensateur (P1, P2) de telle sorte que la structure de remplissage (F) sépare des parts de la couche d'adhérence (HF), et le diélectrique de condensateur (KD) est généré sur la structure de remplissage (F).
